# EUROPEAN PATENT APPLICATION

(11) **EP 4 528 783 A1**
(43) Date of publication of application: **26.03.2025**
(21) Application number: 24201601.2
(22) Date of filing: 20.09.2024
(51) Int. Cl.: H01J 37/20

(54) **SAMPLE CARRIER AND USES THEREOF**

(30) Priority: 22.09.2023 US 202318473035
(71) Applicant: FEI COMPANY, Hillsboro, OR 97124 (US)
(72) Inventor: THOMPSON, Christopher, Eindhoven (NL); SCHAMPERS, Ruud, Eindhoven (NL); PERSOON, Hans, Eindhoven (NL)
(74) Representative: Robinson, Louise Frances

(57) **Abstract**

A sample carrier for a charged particle microscope. The sample carrier comprises a planar or substantially planar body, an opening, and at least one protrusion. The opening is provided in the planar or substantially planar body. The protrusion extends into the opening within a plane defined by the planar or substantially planar body. The protrusion is configured to hold a charged particle microscopy sample.

## Description

### BACKGROUND

The present disclosure relates to a sample carrier for use in a charged particle microscope, and a method of using such a sample carrier in a charged particle microscope. The present embodiments further relate to devices and methods of sample preparation for imaging systems.

### SUMMARY

Charged-particle microscopy is a well-known and increasingly important technique for imaging microscopic objects, particularly in the form of electron microscopy. Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" apparatus (e.g. a FIB-SEM), which additionally employ a "machining" Focused Ion Beam (FIB), allowing supportive activities such as ion-beam milling or Ion-Beam-Induced Deposition (IBID), for example.

In a SEM, irradiation of a specimen by a scanning electron beam precipitates emanation of "auxiliary" radiation from the specimen, in the form of secondary electrons, backscattered electrons, X-rays and photoluminescence (infrared, visible and/or ultraviolet photons), for example; one or more components of this flux of emanating radiation is/are then detected and used for image accumulation purposes.

In a TEM, the electron beam used to irradiate the specimen is chosen to be of a high-enough energy to penetrate the specimen (which, to this end, will generally be thinner than in the case of a SEM specimen); the flux of transmitted electrons emanating from the specimen can then be used to create an image. When such a TEM is operated in scanning mode (thus becoming a STEM), the image in question will be accumulated during a scanning motion of the irradiating electron beam.

More information on some of the topics elucidated here can, for example, be gleaned from the following Wikipedia links:
http://en.wikipedia.org/wiki/Electron_microscope
http://en.wikipedia.org/wiki/Scanning_electron_microscope
http://en.wikipedia.org/wiki/Transmission_electron_microscopy
http://en.wikipedia.org/wiki/Scanning_transmission_electron_microscopy

As an alternative to the use of electrons as irradiating beam, charged particle microscopy can also be performed using other species of charged particle. In this respect, the phrase "charged particle" should be broadly interpreted as encompassing electrons, positive ions (e.g. Ga or He ions), negative ions, protons and positrons, for instance. As regards ion-based microscopy, some further information can, for example, be gleaned from sources such as the following:
http://en.wikipedia.org/wiki/Scanning_Helium_Ion_Microscope

W. H. Escovitz, T. R. Fox and R. Levi-Setti, Scanning Transmission Ion Microscope with a Field Ion Source, Proc. Nat. Acad. Sci. USA 72(5), pp. 1826-1828 (1975).

It should be noted that, in addition to imaging, a charged particle microscope may also have other functionalities, such as performing spectroscopy, examining diffractograms, performing (localized) surface modification (e.g. milling, etching, deposition), etc.

To prepare a sample for a charged particle beam process (such as inspection by transmission electron microscopy (TEM), scanning electron microscopy (SEM), etc.,) the sample is milled into a thin lamella. Some techniques for preparing TEM samples may involve cleaving, chemical polishing, mechanical polishing, or broad beam low energy ion milling. Combinations of these techniques are also possible. These techniques often require that the starting material be sectioned into smaller and smaller pieces, thereby destroying much of the original sample. Other techniques generally referred to as "lift-out" procedures use a focused ion beam (FIB) to cut the sample from a substrate while greatly limiting or eliminating damage to surrounding areas of the substrate. These techniques are useful for analyzing the results of semiconductor manufacture, for example.

A Charged Particle Microscope (CPM) may comprise at least the following components: A radiation source, an illuminator, a specimen holder, and a detector. The radiation source may be a radiation gun such as a Schottky electron source or ion gun. The illuminator may serve to manipulate a "raw" radiation beam from the source and perform certain operations such as focusing, aberration mitigation, cropping (with an aperture), filtering, etc. The illuminator may generally comprise one or more (charged-particle) lenses and may comprise other types of (particle-)optical component also. If desired, the illuminator can be provided with a deflector system that can be invoked to cause its output beam to perform a scanning motion across the specimen being investigated. A specimen under investigation can be held and positioned (e.g. tilted, rotated) by the specimen holder. If desired, this holder can be moved so as to effect scanning motion of the beam with respect to the specimen. In general, such a specimen holder will be connected to a positioning system such as a mechanical stage. The detector may be for detecting radiation emanating from an irradiated specimen which may be unitary or compound/distributed in nature, and which can take many different forms, depending on the radiation being detected. Examples include photomultipliers (including solid state photomultipliers, SSPMs), photodiodes, CMOS detectors, CCD detectors, photovoltaic cells, etc., which may, for example, be used in conjunction with a scintillator film, for instance.

In the case of a transmission-type microscope (such as a (S)TEM, for example), the CPM may also comprise: An imaging system, which essentially takes charged particles that are transmitted through a specimen (plane) and directs (focuses) them onto analysis apparatus, such as a detection/imaging device, spectroscopic apparatus (such as an EELS module), etc. As with the illuminator referred to above, the imaging system may also perform other functions, such as aberration mitigation, cropping, filtering, etc., and it will generally comprise one or more charged-particle lenses and/or other types of particle-optical components.

In addition to imaging, an important aspect of working with a CPM is specimen preparation. This is particularly (though not exclusively) the case in transmission-type CPMs, in which the specimen will generally be extremely thin (e.g. of the order of 1-100 nm), consequently relatively brittle/delicate, and therefore (very) difficult to work with. Once such a specimen is (precariously) mounted on the (specimen mounting zone of the) holder (e.g. using adhesive, or a mechanical clamping mechanism such as a clip, flange, screw, etc.), it is highly desirable not to have to demount it until strictly necessary.

Nevertheless, after mounting, many operations (alterations, finishing) may have to be performed on the specimen, such as ion milling, ion-beam-induced deposition (IBID), electron-beam-induced deposition (EBID), etc., for purposes of thinning, surface modification, etc. Many such functionalities can be made available in situ in a CPM, but their applicability/usefulness is limited in many situations by sub-optimal manipulability of the specimen holder. In this context, the current inventors have worked extensively to identify shortcomings in conventional holder designs, and to address these effectively so as to produce better performance.

Samples for electron microscope imaging require certain preparation for observation under transmitted light or electron radiation. For example, thin slices (or sections) of a sample are typically cut or milled from a bulk sample in a grid or tube. The cutting or milling can be performed by a focused ion beam (FIB) system, or within a dual beam system that includes both a FIB and an electron microscope. Examples of such dual beam systems include the Quanta 3D DualBeam systems from FEI Corporation (Hillsboro, OR, USA).

The process of excavating a sample from a work-piece and attaching the excavated sample to a grid is known from e.g. MAYER, Joachim et al, 'TEM Sample preparation and FIB-induced damage', MRS Bulletin Vol. 32, May 2007, p. 400-407, more specifically page 401: 'In-situ Lift-out/microsampling'.

MAYER describes how a sample is in-situ excavated from a wafer, thinned and attached to a grid in a Focused Ion Beam (FIB) machine. Alternatively, the sample is excavated, then attached to the grid and finally thinned.

A thinned sample is often named a lamella. In this application the phrases 'lamella' and 'sample' are therefore used interchangeable. The resulting lamella is thinned to be transparent to electrons and has a typical thickness of 50 nm or less. The area of the lamella is typically a rectangle with sides of several micrometers to several tens of micrometers large, for example a rectangle with a dimension of 5 µm × 15 µm. After preparing the lamella and attaching the lamella to the lift-out grid the lift-out grid is then positioned such that electron microscopy may be performed, i.e. it may be transferred from the Focused Ion Beam machine to a TEM.

A problem of the known lift-out grid is that, when the sample is welded to the grid, a large part of the emittance solid angle is blocked by the grid, especially near the sample/grid interface. As a result a large fraction of the X-rays cannot be detected, resulting in longer processing times and/or wrong evaluation of the amount of X-rays emitted from the sample. It is noted that the sample is typically only a few µm long, and the foil typically 25 µm thick, resulting in a large shadowing effect, shadowing almost 50% of the emittance solid angle of the X-rays.

A similar problem arises when an X-ray or e-beam tomogram is made, in which the sample is rotated (tilted) over an axis perpendicular to the beam of electrons and at a large number of said tilt angles an image is made. These images at different tilt angles are then used to reconstruct a 3D image of the sample. It is noted that for a tomogram often thicker samples, with a thickness between 70 nm and 1 µm (depending on sample composition) are used.

As part of the sample is shadowed by the grid (either downstream of the beam of electrons or upstream), the tomogram is limited to tilt angles where the sample is not or hardly obscured. Also, the shadowing depends on the tilt angle used. The 3D reconstruction is thus limited in resolution (as only a wedge of the tilt angles that are mechanically possible result in a useful detected signal), especially for the part of the sample near the grid/sample interface.

An additional issue is the transfer of the grid comprising the lamella into a c-clip ring which can result in both mechanical and thermal instabilities.

Thus, what is needed is a sample carrier that provides tomography tilt range of +/- 70 degrees without shadowing the lamella and may also be positioned without the use of a c-clip ring.

In one aspect, the disclosure provides a sample carrier for a charged particle microscope. The sample carrier comprises a planar or substantially planar body, an opening, and at least one protrusion. The opening is provided in the planar or substantially planar body. The protrusion extends into the opening within a plane defined by the planar or substantially planar body. The protrusion is configured to hold a charged particle microscopy sample.

In another aspect, the disclosure provides a method of preparing a sample for inspection in a charged particle microscope. The method comprises providing a sample carrier, connecting the sample carrier to a mechanical stage device of the charged particle microscope, providing a sample, and connecting the sample to a grid member of the sample carrier. The sample carrier includes a planar or substantially planar body, an opening provided in the planar or substantially planar body, and at least one protrusion extending into the opening within a plane defined by the planar or substantially planar body. The protrusion is configured to hold a charged particle microscopy sample.

Other aspects of the disclosure will become apparent by consideration of the detailed description and accompanying drawings.

### BRIEF DESCRIPTION OF THE DRAWINGS

FIG. 1 is a schematic diagram of a top view of the sample carrier according to the disclosure.
FIG. 2 is a schematic diagram of a close-up view of the sample carrier.

### DETAILED DESCRIPTION

Before any implementations of the disclosure are explained in detail, it is to be understood that the disclosure is not limited in its application to the details of construction and the arrangement of components set forth in the following description or illustrated in the following drawings. The disclosure is capable of other implementations and of being practiced or of being carried out in various ways.

In what follows, the disclosure may-by way of example-be set forth in the specific context of electron microscopy. However, such simplification is intended solely for clarity/illustrative purposes and should not be interpreted as limiting.

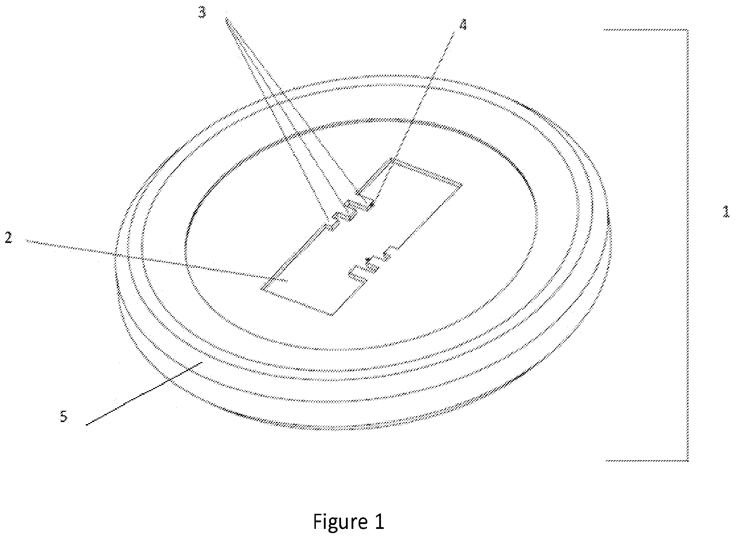

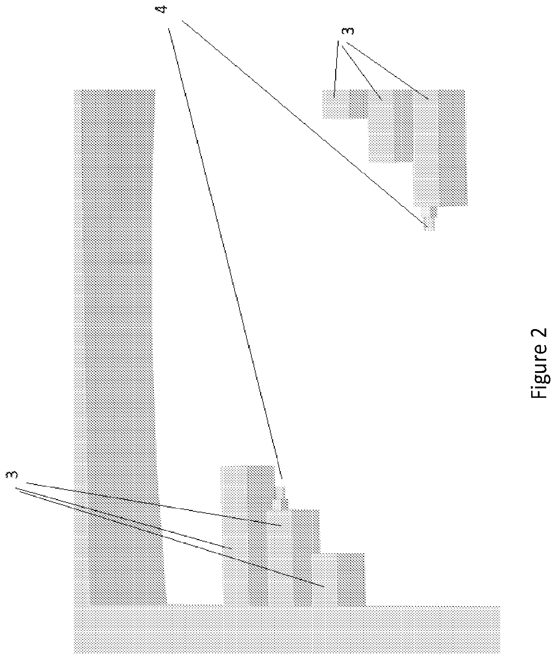

The present disclosure intends to solve at least some of the above issues by the provision of a sample carrier 1 for a charged particle microscope. Figure 1 shows a view of the top of the sample carrier 1 within the scope of the disclosure. As shown, the sample carrier 1 comprises an opening 2 with three protrusions 3 on opposing sides of the opening 2. A sample 4 is positioned on the end of some of the protrusions 3. The sample carrier 1 as shown is substantially circular and has a raised outer edge 5, which can act as a support contour. Figure 2 provides a close up of the protrusions 3 and exemplifies positioning of the sample 4 on the protrusions 3.

The sample carrier 1 comprises a planar or substantially planar body, the opening 2 provided in the planar or substantially planar body, and at least one protrusion 3 extending into the opening 2 within a plane defined by the planar or substantially planar body. The protrusion 3 is configured to hold the charged particle microscopy sample 4.

The charged particle microscope may be any charged particle microscope suitable for imaging objects. In particular, the charged particle microscope may be an electron microscope, such as the Transmission Electron Microscope (TEM), Scanning Electron Microscope (SEM), or Scanning Transmission Electron Microscope (STEM), including various subspecies, such as so-called "dual-beam" apparatus (e.g. a FIB-SEM), which additionally employ a "machining" Focused Ion Beam (FIB), allowing supportive activities such as ion-beam milling or lon-Beam-Induced Deposition (IBID). It may be preferred that the charged particle microscope is a TEM, such as a cryo-TEM.

The sample carrier 1 of the disclosure has a planar or substantially planar body. By the term "planar or substantially planar", we intend that the carrier shape may be substantially flat/level and uninterrupted, or may have openings, divots, or other interruptions therein, and/or may be curved or bent so long as they do not deviate from and/or affect the plane of the carrier as it would be appreciated by the skilled person that such defects may occur during the manufacturing process.

The planar or substantially planar body may be any shape suitable for use as the sample carrier 1. For example, the planar or substantially planar body may be circular (substantially circular), oval (substantially oval), square (substantially square) or rectangular (substantially rectangular). In a preferred aspect, the sample carrier 1 may be circular in shape.

As used herein, the terms "substantially circular", "substantially oval", "substantially square" or "substantially rectangular" are intended to mean that the planar or substantially planar body has a shape that appears circular, oval, square or rectangular, but may have slight deviations from the mathematical definition of circular, oval, square or rectangular as it would be appreciated by the skilled person that such defects may occur during the manufacturing process.

The planar or substantially planar body may be any size suitable for use as the sample carrier 1. For example, the planar or substantially planar body may have a diameter of from about 1mm to about 5mm, such as from about 2.5mm to about 4.5mm or from about 3mm to about 4mm. Preferably the planar or substantially planar body may have a diameter of about 3.5mm.

In an aspect of the disclosure, the planar or substantially planar body may have the raised outer edge 5. That is, the outer edge 5 of the sample carrier 1 may be thicker than the portion within the outer edge 5, which may be referred to hereinafter as "the central portion".

The central portion is preferably thinner than the outer edge 5 of the planar or substantially planar body. The central portion may be any thickness. However, it would be understood by the skilled person that the thickness is designed such that the central portion does not shadow the sample 4 when positioned on the at least one protrusion.

In an aspect of the disclosure, the ratio of the thickness between outer edge 5 of the planar or substantially planar body and the central portion may be from about 1.1: 1 to about 10:1, such as from about 1.5: 1 to about 5:1.

In the sample carrier 1 of the disclosure, there is provided the opening 2 in the planar or substantially planar body. By the term "opening" we intend that the planar or substantially planar body contains an area where the planar or substantially planar body is absent.

Typically, the opening 2 may be located centrally in the planar or substantially planar body.

The opening 2 may be any shape. For example, the opening 2 may be substantially circular, substantially oval, or substantially rectangular. It would be understood by the skilled person that the opening 2 shall be is small as possible to provide mechanical and thermal stability, and large enough to increase the viewable tilt range area.

In an aspect of the disclosure, the opening 2 may be rectangular (substantially rectangular) and located centrally in the circular planar or substantially planar body. In this aspect, the circular or substantially circular planar body may have a diameter of from about 3mm to about 4mm, such as about 3.5mm and/or the rectangular (substantially rectangular) opening 2 may be from about 0.1mm to about 1mm wide and from about 0.5mm to about 1.5mm long.

In the sample carrier 1 of the disclosure, at least one protrusion 3 extends into the opening 2 within the plane defined by the planar or substantially planar body.

The term "protrusion" is intended to mean an area or section of the planar or substantially planar body that extends out from the edge 5 of the opening 2 towards the center of the opening 2 but does not extend completely across the opening 2.

The protrusion 3 may be any shape, but in a preferred aspect may be cuboid or finger-like in shape, where one end of the cuboid or finger is connected to the edge 5 of the opening 2 and the opposite end extends into the opening 2.

The protrusion 3 is configured to hold the charged particle microscopy sample 4. That is, the protrusion 3 must be of sufficient size to hold a charged microscopy sample 4, in particular a lift out sample 4, such as a lift-out cryo-TEM sample 4.

The protrusions 3 may be any size, but the skilled person would appreciate that they must preferably be large enough to hold the required sample 4, yet small enough to avoid shadowing of the sample 4. Any means may be used to attach a sample 4 to the protrusion 3. As a non-limiting example, the sample 4 may be attached by Ion Beam Induced Deposition (IBID).

Typically, in the sample carrier 1 of the disclosure, the opening 2 may comprise at least two protrusions 3 extending into the opening 2 within a plane defined by the planar or substantially planar body. For example, the sample carrier 1 may comprise one, two, three, four, five or six protrusions 3.

Where more than one protrusion 3 is present, the protrusions 3 may be located on the same side or may be located on the opposite side of the opening 2. For example, the sample carrier 1 may comprise one, two, three, four, five or six protrusions 3 on one side of the opening 2, or alternatively, the sample carrier 1 may comprise one, two, three, four, five or six protrusions 3 on one side of the opening 2 and one, two, three four, five or six protrusions 3 on the opposite side of the opening 2.

In a preferred aspect, the sample carrier 1 may comprise one, two or three protrusions 3 on one side of the opening 2 and one, two or three protrusions 3 on the opposite side of the opening 2. For example, the sample carrier 1 may comprise a circular planar or substantially planar body with the centrally located rectangular opening 2, wherein the opening 2 comprises three protrusions 3 on one long edge 5 of the rectangular opening 2 and three protrusions 3 on the opposite long edge 5 of the rectangular opening 2.

Where more than one protrusion 3 is present (i.e. at least two protrusions 3), there may typically be a gap (space) between each protrusion. The gap between each protrusion 3 may be same or different. In a preferred aspect, the gap between each protrusion 3 may be the same.

The gap between protrusions 3 may be any size suitable avoid shadowing the sample 4. Typically, the gap between each protrusion 3 may be from about 0.01mm to about 0.1mm, such as from about 0.04mm to about 0.07mm. Where more than one protrusion 3 is present (i.e. at least two protrusions 3), it may be preferred that the protrusions 3 are staggered with respect to each other. By staggered it is intended to mean that the end of the protrusion 3 not connected to an edge 5 of the opening 2 has extends into the opening 2 by a distance that is different to other protrusions 3 extending from the same edge 5 and/or the protrusions 3 are positioned at differing heights along the edge 5 of the opening 2.

It may be preferred that where two or more protrusions 3 are positioned on a side of the opening 2, the end of each protrusion 3 not connected to an edge 5 of the opening 2 extends further into the opening 2 than the protrusion 3 directly next to it in a step-wise manner. For example, where the opening 2 is a rectangle, it may be preferred that the protrusion 3 located the most centrally on the longest edge 5 of the rectangular opening 2 is the smallest (extends into the opening 2 the shortest/smallest distance) with the protrusions 3 progressively extending further into the opening 2 with the protrusion 3 located closest to the short edge 5 of the rectangular opening 2 being the longest (extends into the opening 2 by the largest distance) or vice versa.

It will be appreciated that the distance which the protrusions 3 extend into the opening 2 will depend on the size of the opening 2. For example, the longest protrusions 3 may extend to half the distance of the opening 2.

In an aspect of the disclosure, the protrusions 3 may increase or decrease in the amount they extend into the opening 2 by the same amount each time. Where more than one protrusion 3 is present (i.e. at least two protrusions 3), it may be preferred that the protrusions 3 do not mirror each other. That is they are not reflectory symmetrical (i.e. they are not positioned directly opposite each other on either side of the opening 2). However, the arrangement of the protrusions 3 in the sample carrier 1 may be rotationally symmetrical. Where more than one protrusion 3 is located on opposite sides of the opening 2 the protrusions 3 may be inversely mirrored on opposing sides of the opening 2. Additionally, or alternatively, where more than one protrusion 3 is present (i.e. at least two protrusions 3), the protrusions 3 may be staggered in a direction substantially orthogonal to the planar body or in a direction substantially parallel to the planar body. The at least two protrusions 3 located on opposite sides may be positioned to not be directly opposite. The at least two protrusions 3 are staggered in a direction substantially parallel to the planar body.

The position of the protrusions 3 directly influences the positioning of the sample 4 attached thereto. As noted above, known sample carriers 1 have issues relating to restrictive tilt positions and/or shadowing of the sample 4.

The unique positioning of the positioning of the protrusions 3 within the sample carrier 1 allow for sample 4 (such as lift out samples) to be viewed with a larger than expected tilt range. In particular, the protrusions 3 of the sample carrier 1 as defined above may provide a +/- 70 degree or 140-degree total tilt range. The tilt range is configured to not shadow the lamella. All lamellae are positioned not in-line with each other to minimize the risk of damaging a lamella while working on another lamella. Additionally, with more than one protrusion 3 present, it would be possible to analyze more than one sample 4 at a different orientation, for example. The sample 4 may be positioned on each protrusion 3 so that it may be viewed in 'normal view' and 'plan view' without having to reposition the sample carrier 1.

The sample carrier 1 may be formed from any material suitable for being used in a charged particle microscope, such as molybdenum or copper. For example, the sample carrier 1 may be formed from a single metal piece, such as copper. The carrier 1 may include an integral mechanical support contour.

The present disclosure also provides a method of preparing a sample 4 for inspection in a charged particle microscope, the method comprising: providing a sample carrier 1 as defined above, connecting said sample carrier 1 to a mechanical stage device of said charged particle microscope, providing a sample 4, and connecting said sample 4 to the grid member of the sample carrier 1.

An advantage of a sample carrier 1 as defined above, is that it may be positioned within a c-clip ring. In particular, the raised edge 5 acts as a support contour and allows for the sample carrier 1 to be positioned in a charged particle microscope without the use of a c-clip ring, which is standard in electron microscopy. Thus, the method of the disclosure may be conducted in the absence of a c-clip ring or other similar holding devices.

Various features and advantages of the disclosure are set forth in the following claims.

## Claims

1. A sample carrier for a charged particle microscope, the sample carrier comprising:
a planar or substantially planar body;
an opening provided in the planar or substantially planar body; and
at least one protrusion extending into the opening within a plane defined by the planar or substantially planar body, wherein the protrusion is configured to hold a charged particle microscopy sample.

2. The sample carrier of claim 1, wherein the opening comprises at least two protrusions extending into the opening within a plane defined by the planar or substantially planar body.

3. The sample carrier of claim 2, wherein the at least two protrusions are staggered.

4. The sample carrier of claim 2, wherein the at least two protrusions are on the same side of the opening.

5. The sample carrier of claim 2, wherein the at least two protrusions are on the opposite sides of the opening.

6. The sample carrier of claim 5, wherein the at least two protrusions are inversely mirrored on opposing sides of the opening.

7. The sample carrier of claim 5, wherein the at least two protrusions located on opposite sides are positioned to not be directly opposite.

8. The sample carrier of claim 3, wherein the at least two protrusions are staggered in a direction substantially orthogonal to the planar body.

9. The sample carrier of claim 3, wherein the at least two protrusions are staggered in a direction substantially parallel to the planar body.

10. The sample carrier of claim 1, wherein the opening is centrally located in the planar or substantially planar body.

11. The sample carrier of claim 1, wherein the opening is substantially rectangular.

12. The sample carrier of claim 1, wherein the charged particle microscopy sample is a lift-out sample.

13. The sample carrier of claim 1, wherein the protrusions provide a 140-degree tilt range.

14. The sample carrier of claim 1, wherein the charged particle microscope is a transmission electron microscope.

15. The sample carrier of claim 1, wherein the carrier is formed from a single metal piece and includes an integral mechanical support contour.

16. The sample carrier of claim 15, wherein the metal piece is copper.

17. A method of preparing a sample for inspection in a charged particle microscope, the method comprising:
providing a sample carrier, the sample carrier including a planar or substantially planar body, an opening provided in the planar or substantially planar body, and at least one protrusion extending into the opening within a plane defined by the planar or substantially planar body, wherein the protrusion is configured to hold a charged particle microscopy sample;
connecting the sample carrier to a mechanical stage device of the charged particle microscope;
providing the charged particle microscopy sample; and
connecting the sample to a grid member of the sample carrier.

18. The method of claim 17, wherein the sample is a lift-out sample.

19. The method according to claim 17, wherein the charged particle microscope is a transmission electron microscope.

20. The method of claim 19, wherein the transmission electron microscope is a cryo-TEM.
